# EUROPEAN PATENT APPLICATION

(11) **EP 2 257 139 A1**
(43) Date of publication of application: **01.12.2010**
(21) Application number: 09161125.1
(22) Date of filing: 26.05.2009
(51) Int. Cl.: H05K 3/18

(54) **Method for manufacturing an article of a synthetic material comprising a metallizable part**

(71) Applicant: Nederlandse Organisatie voor Toegepast -Natuurwetenschappelijk Onderzoek TNO, 2628 VK Delft (NL)
(72) Inventor: Korbee, Roland Alexander, 6133 VR Sittard (NL)
(74) Representative: Hatzmann, Martin

(57) **Abstract**

Method for manufacturing an article of a synthetic material comprising a body part (4) and a metallizable part (5), comprising the steps of manufacturing the body part by any suitable method; providing that the body part is located within an injection mold (1); providing a mixture of a thermoplastic material (7), a metal compound (9) and a suitable compound reduction agent (11); heating said mixture;
feeding the mixture to the injection mold; cooling the injection mold; releasing the article, including the body part and the metallizable part, from the injection mold; removing any remaining reduction agent and/or remaining metal compound from the metallizable part. The result is an article comprising a porous metallizable part (5) including metal metallization germs, which part can be metallized, either electroless or non-electroless.

## Description

The present invention concerns a method for manufacturing an article of a synthetic material comprising a body part and a metallizable part.

Patent application EP 08166714 filed October 15, 2008 by applicant discloses a method for the manufacture of a product including a conductive track, the method comprising steps of manufacturing a body part of the product, providing a mixture of a polymer or monomer and a component having a low molecular mass, providing the body part with said mixture in a shape which corresponds to the desired conductive track, and hardening the mixture. Continued with removing the component having a low molecular mass from the hardened mixture, resulting in a porous track support member and providing said support member with a conductive material. Preferrably, manufacturing of the product is performed by means of a two or more components molding process. A product made in such way may be arranged for enabling a liquid or gaseous medium, e.g. a coolant, to be fed through the porous support member, in order to cool the conductor when the product is in use. The known process may include mixing in, together with said low molecular mass component, small metal particles, functioning as metallization germs, into the polymer, resulting in a porous track support member which includes said metal particles to be used as a basis for metallization the track support member and thus forming a conductive track.
a. Mixing in metal (e.g. copper) particles (e.g. metal powder) has as a disadvantage that they oxidize by air. The metal particles thus will be covered by an oxide layer. This will block access of reactants to the metal particles during (electroless) galvanizing, in other words, the metal particles will work no longer as metallization germs.
b. For manufacturing thin tracks, the metal particles need to be much smaller than the width of the tracks. The smaller the metal particles are, the more they will tend to agglomerate. Due to that it is difficult to disperse such small particles without agglomeration. Agglomeration may be prevented by adding surfactants, which, however, may form a coating at the particles' surface, affecting the particles' effectiveness for metallization.
c. Powder shaped metal compounds are much easier available than powder shaped metals, in particular for very small particle sizes (e.g. about 1 µm). As an example, CuO is commercially available and has a particle size of smaller than 1 µm). When using a metal compound which dissolves, during compounding, in the mixture of the relevant polymer and additive(s), the particle size is even not important at all.

Based on the above findings according to the invention an advanced method for manufacturing an article of a synthetic material comprising a body part and a metallizable part is proposed, comprising the following steps in any suitable order:
- manufacturing the body part by any suitable method;
- providing that the body part is located within an injection mold;
- providing a mixture of a thermoplastic material, a metal compound and a suitable compound reduction agent;
- heating said mixture;
- feeding the mixture to the injection mold;
- cooling the injection mold;
- releasing the article, including the body part and the metallizable part, from the injection mold;
- removing any remaining reduction agent and/or remaining metal compound from the metallizable part.

This method, including the use of a metal compound (instead of a metal) and mixing it with a suitable compound reduction agent and the relevant polymer during processing, causing in situ forming of evenly dispersed metal particles within a polymer matrix, results in a porous polymer part including metallization germs, formed by the dispersed metal particles, which part can be metallized, either electroless or non-electroless, in a successive step. In this connection, a suitable reduction agent or reductor will be defined as any agent which is capable to convert the relevant metal compound into its (uncompounded) metal.

The body part and the metallizable part may be manufactured by injection molding. Optionally, the body part could be manufactured in any alternative way. It may be preferred that the article is manufactured by 2K injection molding, comprising, in any suitable order, a stage wherein the body part is made by injection molding and a stage wherein the metallizable part is made by injection molding, viz. by injection of said (heated) mixture of the relevant thermoplastic material, metal compound and reduction agent

Good results have already been achieved with mixtures wherein the thermoplastic material is a polyamide, the metal compound is a copper oxide and the reduction agent is sorbitol. Other metal compounds may be useful as well. Alternatives for sorbitol comprise other diols, triols and polyols like ethene glycol, propene glycol, mannitol, xylitol, maltitol and lactitol.

Remaining reduction agent and/or remaining metal compound may be removed from the metallizable part by rinsing with water or any other suitable fluid.

Hereinafter the invention will be elucidated more in detail with reference to a figure.
- Figure 1: illustrates a 2K injection mold process for the manufacture of an article of a synthetic material comprising a body part and a metallizable part.
- Figure 2: illustrates a preferred alternative for the process shown in figure 1.

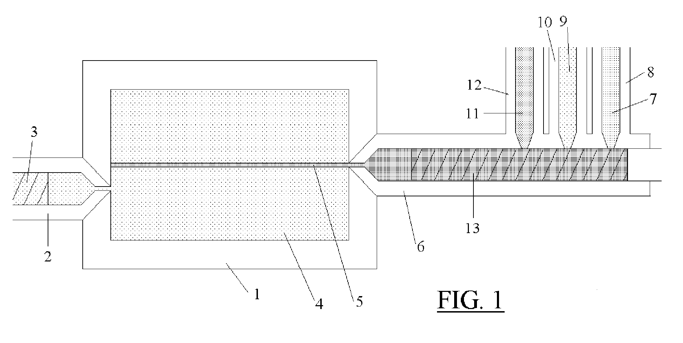

Figure 1 shows schematically an injection mold 1 which is arranged for 2K molding an article of a synthetic material comprising a body part and a metallizable part. A first plastic injection subsystem 2 is provided by which the (heated) thermoplastic material 3 of a body part 4 is injected into the mold 1. A mold insert (not shown) provides that a conduit 5 is formed inside (outside is possible as well) the body part 4 after the body part is solidified and the mold insert is removed.

After this manufacturing of the body part, the body part keeps located within the injection mold.

By means of a second injection subsystem 6 a mixture of a second thermoplastic material (which may be equal to the material of the body part), a metal (e.g. copper) oxide and a suitable compound reduction agent, e.g. sorbitol is made by supplying the second thermoplastic material 7 via a supply channel 8, the metal compound 9 via an supply channel 10 and the reduction agent 11 via the supply channel 12. All those components 7, 9 and 11 are mixed in the subsystem 6, comprising a mixing/transport screw 13, and fed into the mold 1, i.e. into the conduit 5 previously formed in the body part 4, while the mixture is heated by heating means (not shown). During the presence of the mixture in the subsystem 6 the metal compound 9 is mixed with the thermoplastic (monomer or polymer) material and with the reduction agent 11, the latter causing that the metal compound 9 is converted into a metal (and water) which is evenly dispersed in the thermoplastic matrix.

After the mixture has been injected into the mold (i.e. into the conduit 5) the injection mold is cooled after which the article, including the body part 4 and the metallizable part 5, can be released from the injection mold. Before releasing or after it any remaining reduction agent, remaining metal compound and/or the water liberated at the metal compound reduction, is removed from the metallizable part, e.g. by rinsing with water.

The result of this all is a body part 4 which comprises a porous part 5 which includes evenly dispersed metal particles which can be used as metallization germs. When exposing the complete article 4, 5 to an electroless or non-electroless metalizing process, solely part 5 will be metallized, because of the presence of the metallization germs solely at the surface and in the pores of part 5, resulting in an article having an insulating body part 4 and a conductive part 5.

It may be clear that in this way articles can be manufactured having body parts 4 which may have all kinds of shapes and which comprise one or more conductive parts 5 which may have all kinds of shapes as well.

As a test a mixture was made of polyamide 6 (Akulon K 123 available from DSM, Netherlands) mixed with 40% sorbitol. A quantity of 10 mass% of copper(II) oxide was mixed in to this mixture. After heating the mixture to a temperature of 250 °C the copper oxide was at least partly reduced to metallic copper (determined by optical microscopy). The material had the following composition:

| | Wt % | Mass at 3 kg compound |
|---|---|---|
| PA-6 | 54 | 1620 |
| Sorbitol | 36 | 1080 |
| CuO | 10 | 300 |

Because of the forming of metallic copper (probably including copper(I) oxide) the compound had a chocolate-like, brown color. Analysis with a scanning electron microscope (SEM) shows that this contains particles having a size of few micrometers. Particles are present in the compound of Cu₂O and of metallic copper.

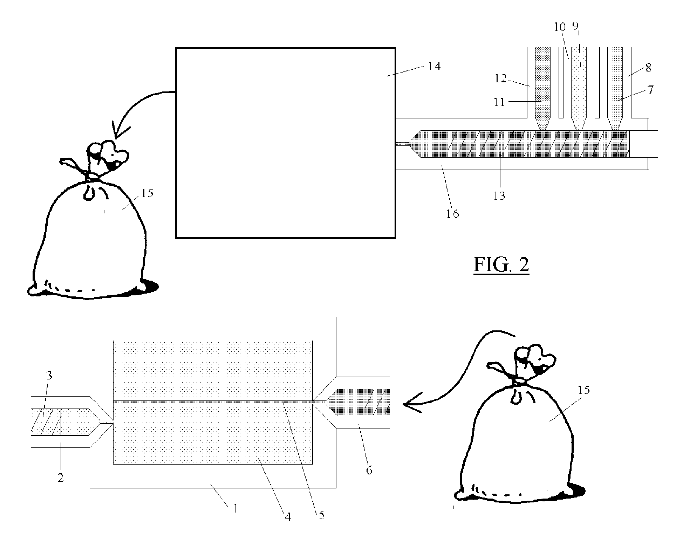

Figure 2 illustrates a preferred alternative for the process shown in figure 1. In this preferred process the mixture of a thermoplastic material, a metal (e.g. copper) oxide and a suitable compound reduction agent, e.g. sorbitol is made by supplying the second thermoplastic material 7 via a supply channel 8, the metal compound 9 via an supply channel 10 and the reduction agent 11 via the supply channel 12 of a separate mixer 16. All those components 7, 9 and 11 are mixed in the mixer 16, comprising a mixing/transport screw 13, and fed into a granulator module 14, in which the output stream of the mixer 16 is cooled down (if required) and granulated. During the presence of the mixture in the mixer 16 the metal compound 9 is mixed with the thermoplastic (monomer or polymer) material and with the reduction agent 11, the latter causing that the metal compound 9 is converted into a metal which is evenly dispersed in the thermoplastic matrix. In that way the output stream of thermoplastic material will include evenly dispersed fine metal particles. Before granulation any remaining reduction agent and/or remaining metal compound may be removed from the output stream by rinsing it, in a rinsing module (not shown), e.g. within module 14, with water. After granulation, in the granulator module 14, the granulate of thermoplastic material having evenly dispersed fine metal particles in it, can be stored in packages 15 and e.g. palletized. Subsequently, the granulate can be fed from the packages 15 to a mold 1, via subsystem 6, giving the same result as the process illustrated in figure 1.

It is noted that any terms used in this document should not be construed so as to limit the scope of the present invention. In particular, the words "comprise(s)" and "comprising" are not meant to exclude any elements not specifically stated. Single elements may be substituted with multiple elements or with their equivalents.

It will be understood by those skilled in the art that the present invention is not limited to the embodiments illustrated above and that many modifications and additions may be made without departing from the scope of the invention as defined in the appending claims.

## Claims

1. Method for manufacturing an article of a synthetic material comprising a body part (4) and a metallizable part (5), comprising the following steps in any suitable order:
- manufacturing the body part by any suitable method;
- providing that the body part is located within an injection mold (1);
- providing a mixture of a thermoplastic material (7), a metal compound (9) and a suitable compound reduction agent (11);
- heating said mixture;
- feeding the mixture to the injection mold;
- cooling the injection mold;
- releasing the article, including the body part and the metallizable part, from the injection mold;
- removing any remaining reduction agent and/or remaining metal compound from the metallizable part.

2. Method according to claim 1, wherein the metallizable part of the article is metallized, either electroless or non-electroless.

3. Method according to claim 1, wherein both the body part and the metallizable part are manufactured by injection molding.

4. Method according to claim 3, wherein the article is manufactured by 2K injection molding, comprising, in any suitable order, a stage wherein the body part is made by injection molding and a stage wherein the metallizable part is made by injection molding.

5. Method according to any preceding claim, wherein the thermoplastic material of said mixture is a polyamide.

6. Method according to any preceding claim, wherein the metal compound of said mixture is a copper oxide.

7. Method according to any preceding claim, wherein the reduction agent of said mixture is selected from a group comprising diols, triols and polyols.

8. Method according to claim 7, wherein the reduction agent of said mixture is selected from a group comprising ethene glycol, propene glycol, mannitol, sorbitol, xylitol, maltitol and lactitol

9. Method according to any preceding claim, wherein any remaining reduction agent and/or remaining metal compound is removed from the metallizable part by rinsing with water.

10. Method for manufacturing granulate of a thermoplastic material including evenly dispersed fine metal particles, comprising the following steps:
- providing a mixture of a thermoplastic material (7), a metal compound (9) and a suitable compound reduction agent (11);
- feeding the mixture to a granulator (14).

11. Granulate manufactured by using the method according to claim 10.

12. Article manufactured by using the method according to any of claims 1 - 9 or manufactured using a granulate manufactured by using the method according to claim 10.
